(19) **Europäisches Patentamt**

**European Patent Office**

**Office européen des brevets**

(11) **EP 0 932 935 B1**

(12) **EUROPEAN PATENT SPECIFICATION**

(45) Date of publication and mention
of the grant of the patent:
**07.01.2004 Bulletin 2004/02**

(51) Int Cl.7: **H03L 7/16**

(86) International application number:
**PCT/IB1998/000255**

(21) Application number: **98903240.4**

(22) Date of filing: **27.02.1998**

(87) International publication number:
**WO 1998/042076 (24.09.1998 Gazette 1998/38)**

(54) **RECEIVER TUNING SYSTEM**

ABSTIMMSYSTEM FÜR EMPFÄNGER

SYSTEME D'ACCORD DE RECEPTEUR

(84) Designated Contracting States:
**DE FR GB**

(30) Priority: **18.03.1997 EP 97200821**

(43) Date of publication of application:
**04.08.1999 Bulletin 1999/31**

(73) Proprietor: **Koninklijke Philips Electronics N.V.**
**5621 BA Eindhoven (NL)**

(72) Inventors:
• **KASPERKOVITZ, Wolfdietrich, Georg**
**NL-5656 AA Eindhoven (NL)**
• **VAUCHER, Cicero, Silveira**
**NL-5656 AA Eindhoven (NL)**

(74) Representative: **Schoenmaker, Maarten et al**
**Philips**
**Intellectual Property & Standards**
**P.O. Box 220**
**5600 AE Eindhoven (NL)**

(56) References cited:
**US-A- 4 488 123**     **US-A- 5 146 186**
**US-A- 5 150 078**     **US-A- 5 508 659**
**US-A- 5 570 066**

• **PATENT ABSTRACTS OF JAPAN; & JP,A,03 148 916 (FUJITSU LTD.) 25 June 1991.**

**Description**

FIELD OF THE INVENTION

The invention relates to a receiver having a tuning system in which a tuning oscillator is synchronized with a stepped-frequency signal having a frequency which can be varied in steps. The invention also relates to the tuning system as such, and to a method of tuning.

BACKGROUND ART

US 5,570,066 discloses a frequency synthesizer comprising a reference oscillator which may be fine tuned with an analog voltage. The output of the reference oscillator is coupled to a frequency synthesizer loop for synchronizing the voltage controlled oscillator with the reference oscillator. The loop includes an adjustable divider for course tuning of the frequency of the voltage controlled oscillator.

US 5,146,186 discloses a frequency synthesizer having a phase locked loop comprising a mixer for multiplying the output signal with an harmonic of a reference signal. The output signal of the mixer, comprising sum and difference frequencies of the input signals of the mixer, is filtered for selecting one of the frequency components.

The phase detector compares the selected frequency component with a signal obtained by dividing and multiplying the frequency of the reference signal. The output of the phase detector is coupled to an oscillator providing the output signal. The above described loop synchronizes the output signal with reference signal. The frequency of the output signal is selectable by selecting, for example, which harmonic of the reference signal to apply to the mixer and which dividing factor to use for the reference frequency.

US 5,150,078 describes a prior-art frequency synthesizer for Doppler radar and communication receivers. The prior-art frequency synthesizer comprises two phase-locked loops (PLLs). The first PLL is a fine or VHF step-tuning loop which provides a fine frequency-step signal. The second or L-band PLL converts the fine frequency-step signal into an L-band frequency signal. It includes an L-band voltage-controlled oscillator (VCO) whose output signal is divided by two and then mixed with the third harmonic of a reference-frequency signal to generate an offset-frequency signal. The phase of the offset-frequency signal is compared with that of a frequency-divided version of the fine frequency-step signal. Accordingly, a phase-difference signal is obtained which controls the frequency and phase of the L-band VCO.

US-A 5,150,078 gives the following example. The fine frequency-step signal has a frequency of 280 MHz. Its frequency is divided by five to obtain a 56 MHz signal. The L-band VCO provides a 1388 MHz output signal. Since this output signal is divided by two, a 694 MHz signal is obtained. The reference-frequency signal at 250 MHz and, consequently, its third harmonic is at 750 MHz. Mixing the third harmonic with the 694 MHz signal provides sum and difference frequencies of which 750-694=56 MHz is selected for phase comparison.

SUMMARY OF THE INVENTION

The invention seeks, inter alia, to provide a receiver which, with respect to the background art, allows a better performance in terms of interference-immunity. Claim 1 defines a tuning system in accordance with the invention. Claims 8, 9 and 10 define a receiver and a method of tuning, respectively, both in accordance with the invention. Additional features, which may be optionally used to implement the invention to advantage, are defined in the dependent claims.

The invention takes the following aspects into consideration. A receiver's performance in terms of interference-immunity depends on the spectral purity of its tuning oscillator. This has the following reason. In practice, any receiver comprises at least one mixer circuit which receives a signal from the tuning oscillator. If the tuning oscillator signal comprises a spectral component which does not have the desired oscillator frequency, the mixer circuit will produce spurious mixing products which may cause interference. The interference may manifest itself as, for example, audible whistles in the case of analog AM and FM radio-reception, visual disturbances in the case of analog TV reception, or an increase in bit-error rate of the recovered information in the case of digital transmission.

The tuning oscillator's spectral purity may be adversely affected if a signal which does not stem from the tuning oscillator itself, leaks into the tuning oscillator. Such signal leakage may be due to, for example, capacitive or inductive coupling between the tuning oscillator and other circuitry in the receiver. The higher the frequency of the leaking signal, the stronger the coupling will be and, consequently, the greater the extent to which the spectral purity of the tuning oscillator will be affected. Furthermore, the nearer in frequency the leaking signal is with respect to the tuning oscillator frequency, the greater the extent to which the spectral purity of the tuning oscillator will be affected. In this respect it should be noted that, in practice, a signal comprises various frequency components such as, for example, a fundamental frequency component and harmonic frequency components.

In the background art, the stepped-frequency single, which is provided by the first PLL, has a frequency of 280 MHz and, consequently, a 1400 MHz fifth harmonic. In practice, this 1400 MHz fifth harmonic will leak into the L-band VCO which has a 1388 MHz oscillation frequency. As a result, the L-band VCO will be parasitically modulated with a 12 MHz frequency which is the difference between the 1388 MHz oscillation frequency and the 1400 MHz fifth harmonic. The L-band VCO's signal will therefore comprise a 1376 MHz frequency component and a 1400 MHz frequency component. If the L-band VCO drives a mixer circuit for converting input signals in frequency, an input signal whose frequency differs 12 MHz from that of the desired signal will be converted to the same frequency as the desired signal and, consequently, will cause interference.

In accordance with the invention, an integer frequency-relationship between the tuning oscillator and the stepped-frequency signal is provided. If the stepped-frequency signal or any of its harmonics leaks into the tuning oscillator, this will not result in any parasitic modulation because of the integer-frequency relationship. In contradistinction to the background art, such signal leakage will, thus not adversely affect the tuning oscillator's spectral purity. Consequently, the invention allows a higher spectral purity of the tuning oscillator and, thus provides a receiver which has a better performance in terms of interference-immunity.

The invention and additional features, which may be optionally used to implement the invention to advantage, are apparent from and will be elucidated with reference to the drawings described hereinafter.

BRIEF DESCRIPTION OF THE DRAWINGS

In the drawings,

Fig. 1 is a conceptual diagram illustrating basic features of the invention:
Figs. 2 to 4 are diagrams illustrating additional features which may be optionally used to implement the invention to advantage; and
Fig. 5 is a block-schematic diagram of an example of a tuning system in accordance with the invention.

DETAILED DESCRIPTION OF THE DRAWINGS

First, some remarks are made on the use of reference signs. Similar entities will be denoted by an identical lettercode throughout the drawings. Various similar entities may be shown in a single drawing. In that case, a numeral will be added to the lettercode to distinguish similar entities from each other. The numeral will be placed between parentheses if the number of similar entities is a running parameter. In the description and in the claims, any numeral in a reference sign may be omitted if this is appropriate.

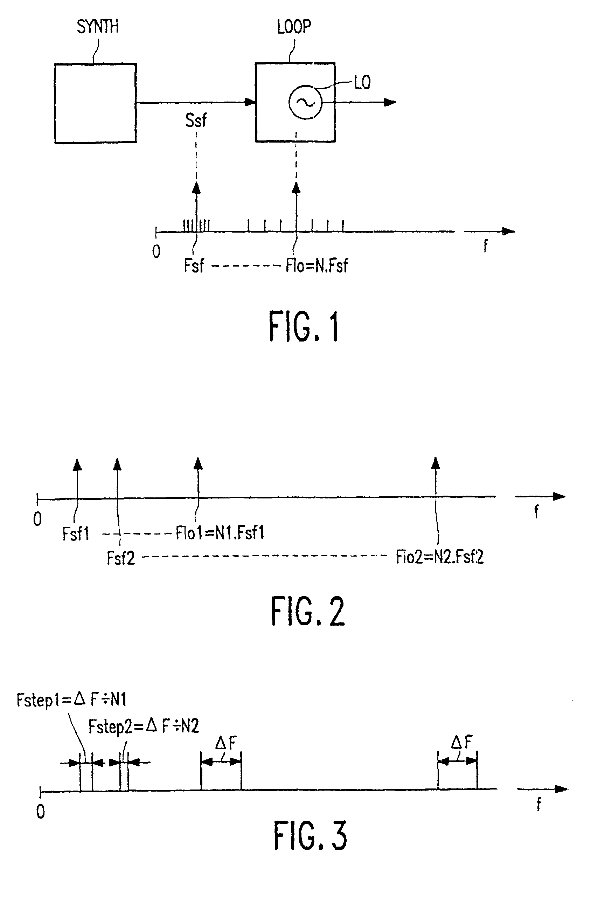

Fig. 1 illustrates basic features of the invention. A frequency-synthesis circuit SYNTH generates a stepped-frequency signal Ssf whose frequency can be varied in steps. A synchronization circuit LOOP synchronizes a tuning oscillator LO with the stepped-frequency signal. The synchronization circuit LOOP provides an integer frequency-relationship between the stepped-frequency signal Ssf and the tuning oscillator LO. That is, if the stepped-frequency signal Ssf has a frequency Fsf, the tuning oscillator LO will operate at a frequency $Flo=N\cdot Fsf$, N being an integer or an integer fraction.

Fig. 2 illustrates the following additional feature. The integer frequency-relationship between the stepped-frequency signal and the tuning oscillator is adjustable. Fig. 2 is a frequency diagram which depicts two different integer frequency-relationships $Flo1=N1\cdot Fsf1$ and $Flo2=N2\cdot Fsf2$, Flo1 and Flo2 being possible tuning-oscillator frequencies, N1 and N2 being two different integer values, and Fsf1 and Fsf2 being two possible frequencies of the stepped-frequency signal.

The Fig. 2 feature takes the following aspects into consideration. The extent to which an oscillator can be tuned, on the one hand, and the spectral purity of the oscillator, on the other hand, are criteria which generally conflict with each other. If an oscillator needs to be tuned throughout a relatively wide frequency range, its frequency needs to change to a relatively large extent as a function of a frequency control signal. Consequently, the oscillator will be relatively sensitive to any disturbance in the frequency control signal, which disturbance may be noise or a signal leaking from another circuit.

If the Fig. 2 feature is applied, the frequency of the stepped-frequency signal needs to be varied throughout a smaller frequency range in order to tune the receiver throughout a desired band, than if the Fig. 2 feature is not applied. Consequently, any oscillator in the frequency-synthesizer circuit which provides the stepped-frequency signal needs to be tuned to a relatively small extent. This will be beneficial to the spectral purity of the stepped-frequency signal, on which the spectral purity of the tuning oscillator also depends, particularly if the synchronization circuit has a relatively large bandwidth. Thus, the Fig. 2 feature contributes to the tuning oscillator's spectral purity and, therefore, to the receiver's performance in terms of interference immunity.

Fig. 3 illustrates the following additional feature. The size of the steps in which the frequency of the stepped-frequency signal can be varied, is adjustable. Fig. 3 shows two different step-sizes Fstep1=$\Delta$F÷N1 and Fstep2=$\Delta$F÷N2, $\Delta$F being a desired uniform tuning step-size. The Fig. 3 feature takes into consideration that the sizes of the steps in which the tuning-oscillator's frequency is varied, is equal to the sizes of the steps in which the stepped-frequency signal is varied, multiplied by the integer frequency-relationship between the tuning oscillator and the stepped-frequency signal. If the Fig. 2 feature is applied, the integer frequency-relationship will not be constant. The Fig. 3 feature allows compensation for this so as to achieve the desired uniform tuning step-size $\Delta$F.

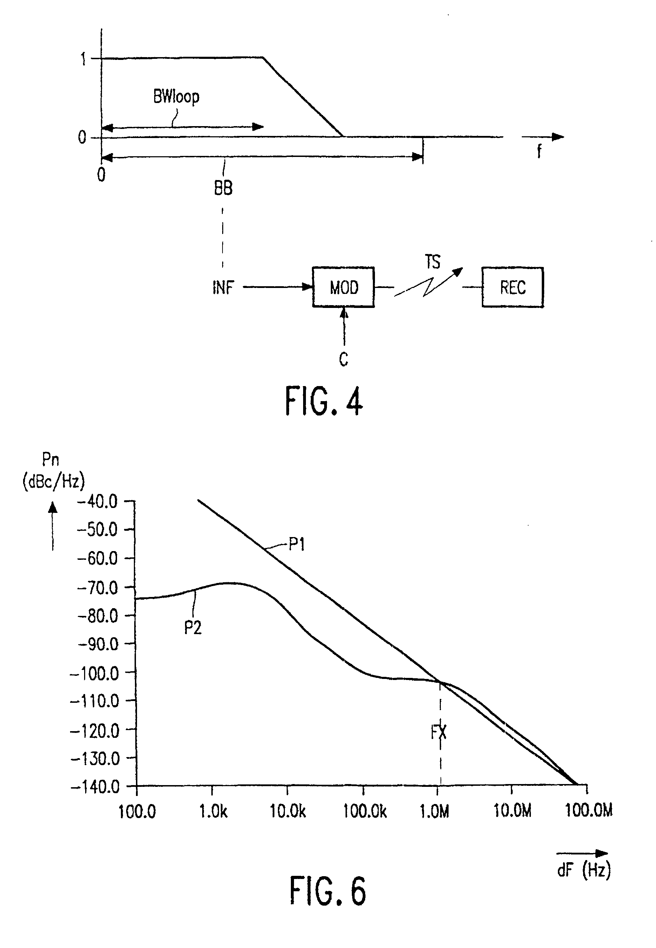

Fig. 4 illustrates the following additional feature. The synchronization circuit has a bandwidth BWloop which covers at least a substantial portion of a typical baseband BB associated with a type of transmission signal which can be processed by the receiver. A transmission signal TS is usually formed by a carrier C which is modulated with information INF. The baseband BB is the frequency band occupied by the information INF which modulates the carrier C. As an example, an analog satellite television broadcast signal is a type of transmission signal which has a typical baseband of, say, 5 MHz. As another example, an FM-radio mono-broadcast signal is a type of transmission signal which has a typical baseband of, say, 15 kHz, whereas an FM-radio stereo-broadcast signal has a typical baseband of, say, 0 to 53 kHz.

Fig. 4 visualizes the bandwidth BWloop of the synchronization circuit by means of a graph. In the graph, the horizontal axis represents the frequency and the vertical axis indicates the extent to which the synchronization circuit reduces a synchronization error between the tuning oscillator and the stepped-frequency signal. The number 1 on the vertical axis means that the synchronization error is practically eliminated, the number 0 means that the synchronization error is not reduced. Synchronization errors which fall within the synchronization circuit's bandwidth BWloop are substantially eliminated, but synchronization errors which fall outside the synchronization circuits's bandwidth BWloop are not reduced or only to a relatively small extent.

The Fig. 4 feature takes the following aspects into consideration. In practice, the tuning oscillator will provide an output signal which comprises a certain amount of noise centred around the oscillation frequency. A frequency conversion in which the tuning oscillator takes part will effectively impose this tuning-oscillator noise on the transmission signal to which the receiver is tuned. This will adversely affect the extent to which the receiver is capable of correctly recovering the information transmitted. In particular, the tuning-oscillator noise which is within a baseband distance from the oscillation frequency, plays an important role in this respect.

If the Fig. 4 feature is applied, the tuning-oscillator noise within a baseband distance from the oscillation frequency will be substantially determined by the noise in the stepped-frequency signal. This is because the synchronization circuit imposes. as it were, the noise in the stepped-frequency signal which is within its bandwidth BWloop, on the tuning oscillator. Consequently, if the tuning oscillator by itself is noisier than the stepped-frequency signal, the synchronization circuit will effectively perform a noise clean-up action within its bandwidth. Thus, the Fig. 4 feature allows use of a relatively noisy tuning oscillator without a significant deterioration of the receiver's performance in terms of correctly recovering the information transmitted. It should be noted that this also applies in the case of a non-integer frequency-relationship between the stepped-frequency signal and the tuning oscillator.

Since the Fig. 4 feature allows use of a relatively noisy tuning oscillator, it also allows the following measures which generally worsen oscillator noise performance. The tuning oscillator may be wholly or partially realized in the form of an integrated circuit. Furthermore, it may also operate with a relatively low supply voltage and with a relatively small power consumption. All these factors contribute to reducing tuning-oscillator radiation which may cause interference problems. In particular, in a direct-conversion receiver, tuning-oscillator radiation needs to be relatively low so as to avoid problems of self-reception. Furthermore, if the tuning oscillator is wholly or partially included in an integrated circuit, it will be relatively easy to obtain mutually phase-shifted tuning-oscillator signals which are required in many types of receivers. As the tuning oscillator may operate with a relatively low supply voltage, it will generally not need a supply voltage which is different from that with which other circuitry operates. In summary, the Fig. 4 feature may contribute to cost-efficiency, low power consumption, and/or overcoming realization problems in many type of receivers.

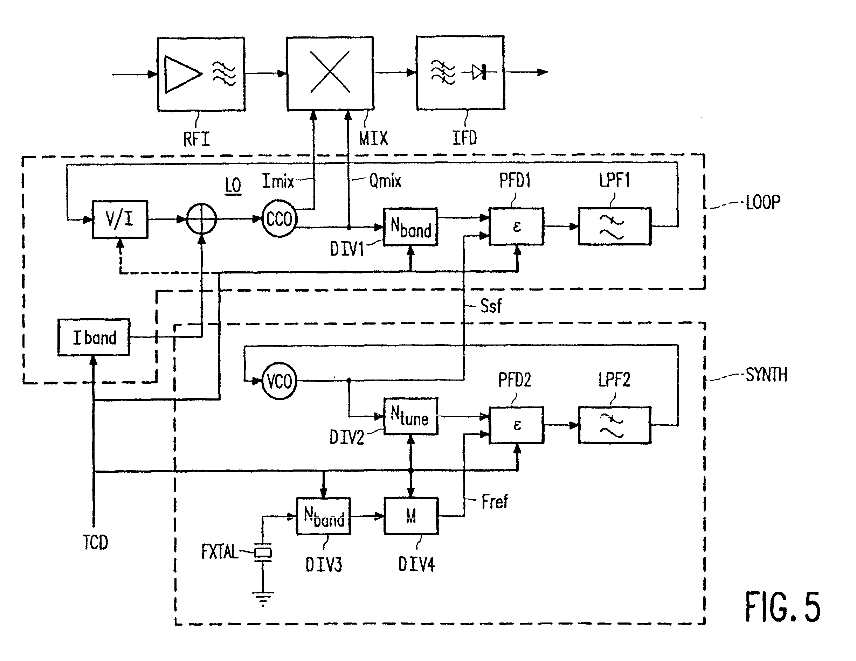

Fig. 5 illustrates an example of a receiver in accordance with the invention which includes the Figs. 1-4 features described hereinbefore. In addition, the Fig. 5 receiver comprises an input circuit RFI, a mixer circuit MIX, and an intermediate frequency and demodulation circuit IFD. The mixer circuit MIX receives in-phase and quadrature mixing-signals Imix and Qmix from the tuning oscillator LO. The synthesizer circuit SYNTH and the synchronization circuit LOOP form, in combination, a tuning system which controls the frequency of the in-phase and quadrature mixing-signals Imix and Qmix in accordance with tuning command data TCD. The tuning command data TCD may be provided by a controller which is not shown in Fig. 5. The functions of the input circuit RFI, the mixer circuit MIX, and the intermediate frequency and demodulation circuit IFD will be clear to those skilled in the art. Therefore, these circuits are not further discussed hereinafter.

The synchronization circuit LOOP provides the following integer frequency-relation ship between the tuning oscillator LO and the stepped-frequency signal Ssf: Flo=Nband•Fsf. To this end, a programmable divider DIV1 divides an output signal of the tuning oscillator LO by a factor of Nband. Accordingly, a frequency-divided tuning oscillator signal is obtained whose frequency is Flo÷Nband. A phase/frequency detector PFD1 provides a synchronization error signal as a function of the synchronization error between the stepped-frequency signal Ssf and the frequency-divided tuning oscillator signal. The synchronization error signal is passed to the tuning oscillator LO via a loop filter LFP1 which has a relatively wide pass-band. The tuning oscillator LO is realized as an integrated RC-type oscillator which comprises a voltage-to-current converter V/I, a band-switching current source Iband and a current controlled oscillator circuit CCO. The band-switching current source Iband may be used to coarsely tune the tuning oscillator LO to a certain frequency band, or a portion thereof, on the basis of the tuning command data TCD.

The frequency-synthesizer circuit SYNTH includes a voltage-controlled oscillator VCO which provides the stepped-frequency signal Ssf. A programmable divider DIV2 divides the frequency of the voltage-controlled oscillator's output signal by a factor of Ntune before it is supplied to a phase/frequency detector PFD2. The phase/frequency detector PFD also receives a signal providing an adjustable reference-frequency Fref which is obtained by carrying out two frequency divisions on a signal from a reference frequency source FXTAL. A programmable divider DIV3 carries out a first frequency division by the factor of Nband. A programmable divider DIV4 carries out a second frequency division by a factor of M. The phase/frequency detector provides, in response to the signals supplied thereto, a frequency control signal to the voltage-controlled oscillator VCO via a loop filter LPF2 which has a relatively narrow pass-band.

The controller, not shown in Fig. 5, calculates the respective division factors Nband, Ntune and M for the programmable dividers DIV1/DIV3, DIV2 and DIV4. The division factor Nband is such that the frequency-divided tuning oscillator signal, whose frequency is Flo÷Nband, falls within a frequency range through which the voltage-controlled oscillator VCO can be tuned. This frequency range may be relatively small if the division factor Nband is adjusted in accordance with the desired tuning-oscillator frequency Flo. In this way, a total frequency range through which the tuning oscillator LO should be tunable, can be effectively divided into different frequency subranges. Each frequency subrange is then associated with a division factor Nband. Since the division factor Nband is also used to divide the signal from the reference-frequency source FXTAL, a constant tuning step-size ΔF is achieved.

The other division factors Ntune and M are calculated on the basis of the following equations:

$$Ntune = Flo \cdot M \div Fxtal$$

$$M = Fxtal \div \Delta F$$

In these equations, Fxtal represents the frequency of the signal provided by the reference-frequency source FXTAL. It should be noted that the equations are simple mathematic operations that can be easily carried out by the controller. This fact contributes to a relatively easy and cost-efficient application of the Fig. 5 receiver.

The table below illustrates an application of the Fig. 5 receiver in the field of digital satellite TV-reception. Digital satellite TV-broadcasting takes place in a frequency range between, say, 950 MHz and 2150 MHz. With respect to the table below, it is assumed that the Fig. 5 receiver is of the direct-conversion type. The tuning oscillator LO is tuned throughout the frequency range between 950 MHz and 2150 MHz in 1 MHz steps. The 1 Mhz steps may be obtained, for example, if the reference-frequency source FXTAL provides a 4 Mhz signal and the division ratio M is 4. The rows of the table represent four frequency subranges SR1, SR2, SR3 and SR4 into which the frequency range between 950 MHz and 2150 MHz is effectively divided. The columns of the table list the following for each of the four frequency subranges SR1, SR2, SR3 and SR4: the frequency of the tuning oscillator Flo. the division factor Nband, the adjustable reference-frequency Fref, and the division factor Ntune, respectively.

|  | Flo (MHz) | Nband | Fref (kHz) | Ntune |
|---|---|---|---|---|
| SR1 | 950-1228 | 4 | 250 | 950-1228 |
| SR2 | 1228-1535 | 5 | 200 | 1228-1535 |
| SR3 | 1535-1840 | 6 | 166.67 | 1535-1840 |
| SR4 | 1840-2150 | 7 | 142.85 | 1840-2150 |

The voltage-controlled oscillator VCO only needs to be tuned throughout a relative small frequency range between 237 MHz and 307 MHz.

Fig. 6 illustrates the noise behavior of the tuning oscillator LO in the above-described application of the Fig. 5 receiver. Fig. 6 is a graph of noise power spectral density Pn versus a distance in frequency dF with respect to the oscillation frequency. The noise power spectral density Pn is expressed in decibels with respect to the carrier power per Hertz (dBc/Hz). Fig. 6 shows two plots P1 and P2 which represent, respectively, the noise behavior of the tuning oscillator LO by itself, and the noise behavior when it forms part of the Fig. 5 receiver. Fig. 6 visualizes the noise clean-up action which the synchronization circuit LOOP carries out below a frequency FX. The frequency FX approximately corresponds to the bandwidth BWloop of the synchronization circuit LOOP.

The Fig. 5 receiver includes some additional features which have not been highlighted hereinbefore. The use of phase/frequency detectors contributes to a reliable and relatively fast operation of the Fig. 5 receiver. The use of phase/frequency detectors is also advantageous in terms of spectral purity, because phase/frequency detectors produce relatively few spurious products. European patent application 96202486.5 (attorney's docket PHN 15.978), which is herein incorporated by reference, describes suitable phase/frequency detectors. Another additional feature, which is included in the Fig. 5 receiver, is that the phase/frequency detectors have programmable characteristics. That is, the magnitude of the output signal for a certain synchronization error is adjustable. Accordingly, a change in the frequency division factors of programmable dividers DIV1 and DIV2 may be compensated for so as to keep the bandwidth BWloop of the synchronization circuit LOOP, and that of the synthesizer circuit SYNTH, substantially constant. This may be important, because in many applications the bandwidth is a delicate compromise between various performance aspects.

The drawings and their description hereinbefore illustrate rather than limit the invention. Evidently, there are numerous alternatives which fall within the scope of the appended Claims. In this respect, the following closing remarks are made.

There are numerous ways of physically spreading functions or functional elements over various units. In this respect, the drawings are very diagrammatic and represent only one possible embodiment of the invention.

Any reference signs between parentheses shall not be construed as limiting the Claim concerned.

**Claims**

1. A tuning system comprising:

   a frequency-synthesis loop (SYNTH) for generating a stepped-frequency signal (Ssf) having a frequency (Fsf) which can be varied in steps, the frequency-synthesis loop (SYNTH) comprising a reference frequency source (FXTAL) having a reference frequency (Fxtal) and a first divider (DIV3); and
   a synchronization circuit (LOOP) for synchronizing a tuning oscillator (LO) having a tuning-oscillator frequency (Flo) with the stepped-frequency signal (Ssf), the synchronization circuit (loop) comprising a second divider (DIV1),

   **characterized in that** the first divider (DIV3) is coupled to the reference frequency source (FXTAL) for dividing the reference frequency (Fxtal) by an integer factor ($N_{band}$), and **in that** the second divider (DIV1) is coupled to the tuning oscillator (LO) for dividing the tuning-oscillator frequency (Flo) by the integer factor ($N_{band}$) to provide an integer frequency-relationship (Flo = $N_{band}$.Fsf) between the frequency (Fsf) of the stepped-frequency signal (Ssf) and the tuning-oscillator frequency (Flo).

2. A tuning system as claimed in claim 1, **characterized in that** the frequency synthesized loop (SYNTH) comprises a third divider (DIV2) for dividing the frequency (Fsf) of the stepped frequency signal (Ssf) by another factor ($N_{tune}$), the loop being adapted for providing a relationship between the reference frequency (Fxtal) and the frequency (Fsf) of:

$$Fxtal/(N_{band}.M) = Fsf/N_{tune,,}$$

3. A tuning system as claimed in claim 2, **characterized in that** a range of tuning-oscillator frequencies (Flo) is selectable by selecting combinations of the factor ($N_{band}$) and the other factor ($N_{tune}$), the combinations resulting in a range of frequencies (Fsf) which is relatively a smaller range than the range of tuning-oscillator frequencies (Flo).

4. A tuning system as claimed in claim 1, **characterized in that** the synchronization circuit (LOOP) includes a phase/frequency detector (PFD1) for providing a frequency control signal to the tuning oscillator (LO) a function of a synchronization error between the stepped-frequency signal (Ssf) and the tuning oscillator (LO).

5. A tuning system as claimed in claim 4, **characterized in that** the relation between the frequency control signal and the synchronization error is adjustable.

**6.** A tuning system as claimed in claim 5, **characterized in that** the relation adjustable in dependence on the factor ($N_{band}$) so as to reduce bandwidth variations of the synchronization circuit (LOOP).

**7.** A tuning system as claimed in claim 1, **characterized in that** the frequency synthesis loop (SYNTH) includes a voltage controlled oscillator (CO) for providing the stepped frequency signal (Ssf) and a frequency detector (PFD2) for providing a frequency control signal to the voltage controlled oscillator (VCO) as function of a synchronization error between the stepped frequency signal (Ssf) and the reference oscillator (FXTAL).

**8.** A receiver comprising a tuning system as claimed in claim 1, further comprising a mixer coupled to the tuning oscillator.

**9.** A receiver as claimed in claim 8, **characterized in that** the synchronization circuit (LOOP) has a bandwidth (BWloop) which covers at least a substantial portion of a typical baseband (BB) associated with a type of transmission signal (TS) processable by the receiver.

**10.** A method of tuning comprising the steps of:

generating a stepped-frequency signal (Ssf) having a frequency (Fsf) which can be varied in steps; and synchronizing a tuning oscillator (LO) having a tuner-oscillator frequency (Flo) with the stepped-frequency signal (Ssf), **characterized in that** the step of generating comprises:

dividing a reference frequency by an integer factor ($N_{band}$); and the step of synchronizing comprises:

dividing the tuning-oscillator frequency (Flo) by the integer factor ($N_{band}$) to provide an integer frequency-relationship (Flo = $N_{band}$.Fsf) between the frequency (Fsf) of the stepped-frequency signal (Ssf) and the tuning-oscillator frequency (Flo).

**Patentansprüche**

**1.** Abstimmsystem, das die nachfolgenden Elemente umfasst:

- eine Frequenz-Syntheseschleife (SYNTH) zum Erzeugen eines gestuften Frequenzsignals (Ssf) mit einer Frequenz (Fsf), die stufenweise variiert werden kann, wobei die Frequenz-Syntheseschleife (SYNTH) eine Bezugsfrequenzquelle (FXTAL) mit einer Bezugs frequenz (Fxtal), sowie einen ersten Teiler (DIV3) aufweist; und
- eine Synchronisationsschaltung (LOOP) zum Synchronisieren eines Abstimmoszillators (LO) mit einer Abstimmoszillatorfrequenz (Flo) mit dem gestuften Frequenzsignal (Ssf), wobei die Synchronisationsschaltung (loop) einen zweiten Teiler (DIV1) aufweist,

**dadurch gekennzeichnet, dass** der erste Teiler (DIV3) mit der Bezugsfrequenzquelle (FXAL) zum Teilen der Bezugsfrequenz (Fxtal) durch einen ganzzahligen Faktor ($N_{band}$) gekoppelt ist und das der zweite Teiler (DIV1) mit dem Abstimmoszillator (LO) gekoppelt ist zum Teilen der Abstimmoszillatorfrequenz (Flo) durch einen ganzzahligen Faktor ($N_{band}$) zum Liefern eines ganzzahligen Frequenzverhältnisses (Flo = $N_{band}$.Fsf) zwischen der Frequenz (Fsf) des gestuften Frequenzsignals (Ssf) und der Abstimmoszillatorfrequenz (Flo).

**2.** Abstimmsystem nach Anspruch 1, **dadurch gekennzeichnet, dass** die Frequenz-Syntheseschleife (SYNTH) einen dritten Teiler (DIV2) aufweist zum Teilen der Frequenz (Fsf) des gestuften Frequenzsignals (Ssf) durch einen anderen Faktor ($N_{tune}$), wobei die Schleife vorgesehen ist zum Schaffen einer Beziehung zwischen der Bezugsfrequenz (Fxtal) und der Frequenz (Fsf), und zwar:

$$Fxtal(N_{band}.M) = Fsf/N_{tune}.$$

**3.** Abstimmsystem nach Anspruch 2, **dadurch gekennzeichnet, dass** ein Gebiet von Abstimmoszillatorfrequenzen (Flo) dadurch selektierbar ist, dass Kombinationen des Faktors ($N_{band}$) und des anderen Faktors ($N_{tune}$) selektiert werden, wobei die Kombinationen zu einem Gebiet von Frequenzen (Fsf) führen, das verhältnismäßig ein kleineres Gebiet ist als das Gebiet der Abstimmoszillatorfrequenzen (Flo).

**4.** Abstimmsystem nach Anspruch 1, **dadurch gekennzeichnet, dass** die Synchronisationsschaltung (LOOP) einen Phasen/Frequenzdetektor (PFD1) aufweist zum Schaffen eines Frequenzsteuersignals für den Abstimmoszillator (LO) als eine Funktion eines Synchronisationsfehlers zwischen dem gestuften Frequenzsignal (Ssf) und dem Abstimmoszillator (LO).

**5.** Abstimmsystem nach Anspruch 4, **dadurch gekennzeichnet, dass** die Beziehung zwischen dem Frequenzsteuersignal und dem Synchronisationsfehler einstellbar ist.

**6.** Abstimmsystem nach Anspruch 5, **dadurch gekennzeichnet, dass** die Beziehung in Abhängigkeit von dem Faktor ($N_{band}$) einstellbar ist, und zwar zum Reduzieren der Bandbreitenvariationen der Synchronisationsschaltung (LOOP).

**7.** Abstimmsystem nach Anspruch 1, **dadurch gekennzeichnet, dass** die Frequenz-Syntheseschleife (SYNTH) einen spannungsgeregelten Oszillator (CO) aufweist zum Schaffen des gestuften Frequenzsignals (Ssf) und einen Frequenzdetektor (PFD2) zum Schaffen eines Frequenzregelsignals für den spannungsgeregelten Oszillator (VCO) als eine Funktion eines Synchronisationsfehlers zwischen dem gestuften Frequenzsignal (Ssf) und dem Bezugsoszillators (FXTAL).

**8.** Empfänger mit einem Abstimmsystem nach Anspruch 1, weiterhin mit einer Mischstufe, die mit dem Abstimmoszillator gekoppelt ist.

**9.** Empfänger nach Anspruch 8, **dadurch gekennzeichnet, dass** die Synchronisationsschaltung (LOOP) eine Bandbreite (BWloop) hat, die wenigstens einen wesentlichen Teil eines typischen Basisbandes (BB) bedeckt, das mit einem Typ eines Übertragungssignals (TS) assoziiert ist, das durch den Empfänger verarbeitet werden kann.

**10.** Abstimmverfahren, wobei dieses Verfahren die nachfolgenden Verfahrensschritte umfasst:

- das Erzeugen eines gestuften Frequenzsignals (Ssf) mit einer Frequenz (Fsf), die stufenweise variiert werden kann; und
- das Synchronisieren eines Abstimmoszillators (LO) mit einer Abstimmoszillatorfrequenz (Flo) mit einem gestuften Frequenzsignal (Ssf), **dadurch gekennzeichnet, dass** der Verfahrensschritt der Erzeugung Folgendes umfasst:

  - das Teilen einer Bezugsfrequenz durch einen ganzzahligen Faktor ($N_{band}$); und dass der Verfahrensschritt der Synchronisation Folgendes umfasst:

    - das Teilen der Abstimmoszillatorfrequenz (Flo) durch den ganzzahligen Faktor ($N_{band}$) zum Schaffen eines ganzzahligen Frequenzverhältnisses (Flo = $N_{band}$.Fsf) zwischen der Frequenz (Fsf) des gestuften Frequenzsignals (Ssf) und der Abstimmoszillatorfrequenz (Flo).

**Revendications**

**1.** Système d'accord comprenant :

une boucle de synthèse de fréquence (SYNTH) destinée à produire un signal à fréquence échelonnée (Ssf) ayant une fréquence (Fsf) pouvant être amenée à varier pas à pas, la boucle de synthèse de fréquence (SYNTH) comprenant une source de fréquence de référence (FXTAL) ayant une fréquence de référence (Fxtal) et un premier diviseur (DIV3) ; et
un circuit de synchronisation (LOOP) pour synchroniser un oscillateur d'accord (LO) ayant une fréquence d'oscillateur d'accord (Flo) avec le signal à fréquence échelonnée (Ssf), le circuit de synchronisation (LOOP) comprenant un deuxième diviseur (DIV1),

**caractérisé en ce que** le premier diviseur (DIV3) est couplé à la source de fréquence de référence (FXTAL) pour diviser la fréquence de référence (Fxtal) par un facteur entier ($N_{band}$), et **en ce que** le deuxième diviseur (DIV1) est couplé à l'oscillateur d'accord (LO) pour diviser la fréquence (Flo) de l'oscillateur d'accord par le facteur entier

($N_{band}$) afin d'établir une relation de fréquence entière (Flo = $N_{band}$·Fsf) entre la fréquence (Fsf) du signal à fréquence échelonnée (Ssf) et la fréquence (Flo) de l'oscillateur d'accord.

**2.** Système d'accord selon la revendication 1, **caractérisé en ce que** la boucle de synthèse de fréquence (SYNTH) comprend un troisième diviseur (DIV2) pour diviser la fréquence (Fsf) du signal à fréquence échelonnée (Ssf) par un autre facteur ($N_{tune}$), la boucle étant conçue pour établir une relation entre la fréquence de référence (Fxtal) et la fréquence (Fsf) définie par :

$$Fxtal/(N_{band} \cdot M) = Fsf/N_{tune}.$$

**3.** Système d'accord selon la revendication 2, **caractérisé en ce que** la gamme de fréquences (Flo) de l'oscillateur d'accord peut être sélectionnée par sélection de combinaisons du facteur ($N_{band}$) et de l'autre facteur ($N_{tune}$), les combinaisons conduisant à une gamme de fréquences (Fsf) qui est une gamme relativement inférieure à la gamme de fréquences (Flo) de l'oscillateur d'accord.

**4.** Système d'accord selon la revendication 1, **caractérisé en ce que** le circuit de synchronisation (LOOP) comporte un détecteur de phase/fréquence (PFD1). pour fournir un signal de commande de fréquence à l'oscillateur d'accord (LO) qui est une fonction d'une erreur de synchronisation entre le signal à fréquence échelonnée (Ssf) et l'oscillateur d'accord (LO).

**5.** Système d'accord selon la revendication 4, **caractérisé en ce que** la relation entre le signal de commande de fréquence et l'erreur de synchronisation est réglable.

**6.** Système d'accord selon la revendication 5, **caractérisé en ce que** la relation est réglable en fonction du facteur ($N_{band}$) de façon à réduire les variations de la largeur de bande du circuit de synchronisation (LOOP).

**7.** Système d'accord selon la revendication 1, **caractérisé en ce que** la boucle dé synthèse de fréquence (SYNTH) comporte un oscillateur commandé en tension (CO) pour fournir le signal à fréquence échelonnée (Fsf) et un détecteur de fréquence (PFD2) pour fournir un signal de commande de fréquence à l'oscillateur commandé en tension (VCO) en fonction d'une erreur de synchronisation entre le signal à fréquence échelonnée (Ssf) et l'oscillateur de référence (FXTAL).

**8.** Récepteur comprenant un système d'accord selon la revendication 1, comprenant en outre un mélangeur couplé à l'oscillateur d'accord.

**9.** Récepteur selon la revendication 8, **caractérisé en ce que** le circuit de synchronisation (LOOP) a une largeur de bande (BWloop) qui couvre au moins une partie notable d'une bande de base typique (BB) associée à un type de signal de transmission (TS) pouvant être traité par le récepteur.

**10.** Procédé d'accord comprenant les étapes de :

production d'un signal à fréquence échelonnée (Ssf) ayant une fréquence (Fsf) pouvant être amenée à varier par pas ; et
synchronisation d'un oscillateur d'accord (LO) ayant une fréquence (Flo) d'oscillateur d'accord avec un signal à fréquence échelonnée (Ssf), **caractérisé en ce que** l'étape de production comprend :

la division d'une fréquence de référence par un facteur entier ($N_{band}$) ; et **en ce que** l'étape de synchronisation comprend :

la division de la fréquence (Flo) de l'oscillateur d'accord par le facteur entier ($N_{band}$) pour établir une relation de fréquence entière (Flo = $N_{band}$·Fsf) entre la fréquence (Fsf) du signal à fréquence échelonnée (Ssf) et la fréquence (Flo) de l'oscillateur d'accord.

SYNTH                    LOOP

                                    LO

                    Ssf

0        Fsf ――――――― Flo=N.Fsf        f

## FIG. 1

0    Fsf1 ――――――― Flo1=N1.Fsf1
         Fsf2 ――――――――――――――― Flo2=N2.Fsf2        f

## FIG. 2

Fstep1=ΔF÷N1
     Fstep2=ΔF÷N2      ΔF          ΔF

0                                              f

## FIG. 3

FIG. 4

FIG. 6

FIG.5